(19) Europäisches Patentamt
European Patent Office
Office européen des brevets

(11) Publication number: 0 113 187 B1

(12) # EUROPEAN PATENT SPECIFICATION

(45) Date of publication of patent specification: 29.03.89

(51) Int. Cl.$^4$: G 11 C 11/24

(21) Application number: 83307270.5

(22) Date of filing: 29.11.83

(54) A dynamic semiconductor memory device.

(30) Priority: 01.12.82 JP 211146/82

(43) Date of publication of application: 11.07.84 Bulletin 84/28

(45) Publication of the grant of the patent: 29.03.89 Bulletin 89/13

(84) Designated Contracting States: DE FR GB

(56) References cited:
EP-A-0 050 529
EP-A-0 063 483
US-A-4 240 092

(73) Proprietor: FUJITSU LIMITED
1015, Kamikodanaka Nakahara-ku
Kawasaki-shi Kanagawa 211 (JP)

(72) Inventor: Takemae, Yoshihiro
303, 8-13-24, Akasaka
Minato-ku Tokyo 107 (JP)
Inventor: Sato, Kimiaki
204, 4-11-35, Minamiazabu
Minato-ku Tokyo 106 (JP)
Inventor: Nakano, Tomio
12-404, 1-11-2, Shirahatadai Miyamae-ku
Kawasaki-shi Kanagawa 213 (JP)

(74) Representative: Rackham, Stephen Neil et al
GILL JENNINGS & EVERY 53-64 Chancery Lane
London WC2A 1HN (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 113 187 B1

## Description

The present invention relates to a dynamic semiconductor memory device, and more particularly to a voltage dividing circuit in a one-transistor one-capacitor dynamic semiconductor memory device.

In general, a one-transistor one-capacitor dynamic random access memory (RAM) comprises a one-transistor one-capacitor dynamic memory cell, a word line, a bit line, and a voltage dividing circuit having a potential-providing terminal for providing an intermediate potential between a power supply potential and a ground potential; the single transistor of the cell having a gate electrode connected to the word line and having two other electrodes; the single capacitor of the cell having a first electrode, which is connected to one of the said other electrodes of the transistor, and an opposite electrode which is operatively connected to the potential-providing terminal of the voltage dividing circuits. Such a device is described in EP—A—0050529.

The reason for connecting the opposite electrode to the point having the intermediate potential is as follows. Accompanied by an improvement in the integration density of a semiconductor memory device, the area of the electrodes of the capacitor in the memory cell has been more and more decreased. In order to obtain a desired capacitance by the capacitor having such a small area as above, the thickness of an insulating film between the electrodes of the capacitor is made thin. Because of the thin insulating film, the tolerance voltage of the insulating film is lowered. Therefore, the voltage applied between the electrodes of the capacitor is preferably small and is set to an intermediate potential such as $V_{CC}/2$ rather than $V_{CC}$.

The present invention starts from such a conventional dynamic RAM as above in which the opposite electrode of the capacitor in each memory cell is connected to the point having the potential $V_{CC}/2$.

Two resistors are conventionally used for providing the potential $V_{CC}/2$. That is, two resistors having the same resistance are connected in series between the power supply line and the ground line so as to provide the potential $V_{CC}/2$ at the connecting point between the two resistors, and the opposite electrode of the capacitor in each memory cell is connected to the connecting point between the resistors. By this construction, however, the potential at the opposite electrode fluctuates in response to internal clock signals or operation of the memory device due to parasitic capacitance in the memory device as described later in detail with reference to the drawings. Consequently read errors often occur, as described later in detail.

According to this invention in such a memory the voltage-dividing circuit comprises a potential switching circuit for changing the intermediate potential in the voltage dividing circuit synchronously with the operation of the memory device to provide a potential at which the intermediate potential is shifted towards the direction of the potential change of the opposite electrode of the capacitor due to capacitive coupling accompanied by the memory operation.

In one embodiment of the present invention, the voltage dividing circuit comprises a first resistor and a second resistor connected in series between a power supply line and a ground line and the potential switching circuit in the voltage-dividing circuit comprises a third resistor and a switching transistor having a control electrode for turning on or off the switching transistor and having two other electrodes. One end of the third resistor is connected to a connecting point between the first resistor and the second resistor, and the other end of the third resistor is connected to one of the two other electrodes of the switching transistor. The other of the two other electrodes of the switching transistor is connected to the ground line or the power supply line, the connecting point being the potential providing terminal.

In another embodiment of the present invention, the voltage dividing circuit comprises a first resistor and a second resistor connected in series between a power supply line and a ground line, a third resistor and a fourth resistor connected in series between the power supply line and the ground line, a first switching transistor having a first control electrode for turning on or off the first switching transistor and having two other electrodes, and a second switching transistor having a second control electrode for turning on or off the second switching transistor and having two other electrodes. One of the two other electrodes of the first switching transistor is connected to a first connecting point between the first resistor and the second resistor and one of the two other electrodes of the second switching transistor is connected to a second connecting point between the third resistor and the fourth resistor. The other of the two other electrodes of the first switching transistor and the other of the two other electrodes of the second switching transistor are commonly connected to the potential-providing terminal. The first control electrode operatively receives a first internal clock signal and the second control electrode operatively receives a second internal clock signal having a phase different by 180° with respect to the phase of the first internal clock signal.

The above objects and features of the present invention will be more apparent from the following description of the preferred embodiments of the present invention in comparison with the conventional device, with reference to the accompanying drawings, wherein:

Figure 1 is a conventional circuit diagram of a part of a conventional dynamic RAM;

Fig. 2A is a waveform diagram explaining a normal operation of the circuit shown in Fig. 1;

Fig. 2B is a waveform diagram of a long interval of the waveform shown in Fig. 2A;

Fig. 3A is a waveform diagram explaining an abnormal operation of the circuit shown in Fig. 1;

Fig. 3B is a waveform diagram explaining a read error operation of the circuit shown in Fig. 1;

Fig. 4 is a circuit diagram of a part of a dynamic RAM, according to an embodiment of the present invention;

Fig. 5A is a waveform diagram explaining the operation of the circuit shown in Fig. 4 when a reset interval is longer than an active interval;

Fig. 5B is a waveform diagram explaining the operation of the circuit shown in Fig. 4 when an active interval is longer than a reset interval;

Fig. 6 is a circuit diagram of a part of a dynamic RAM, according to another embodiment of the present invention; and

Fig. 7 is a waveform diagram explaining the operation of the circuit shown in Fig. 5.

Before describing the preferred embodiments, a conventional example and the problems therein will first be described with reference to Figs. 1, 2A, 2B, 3A, and 3B.

In Fig. 1, a conventional dynamic RAM comprises a voltage dividing circuit 1 for providing the potential $V_{CC}/2$, and a memory cell 2 consisting of a metal-oxide semiconductor (MOS) transistor $Q_1$ and a capacitor $C_1$. The gate of the MOS transistor $Q_1$ is connected to a word line $WL_1$. One of the other two electrodes (source and drain) of the MOS transistor $Q_1$ is connected via a node $N_1$ to one electrode of the capacitor $C_1$. The other electrode of the MOS transistor $Q_1$ is connected to a bit line $BL_1$. The bit line $BL_1$ and a bit line $\overline{BL}_1$ constitute a bit line pair. A sense amplifier SA is connected between the bit lines $BL_1$ and $\overline{BL}_1$. A dummy memory cell (not shown) for storing reference information when the memory cell 2 is to be read is connected to the bit line $\overline{BL}_1$. The voltage dividing circuit 1 consists of two resistors $R_1$ and $R_2$ connected in series between a power supply line $V_{CC}$ and a ground line $V_{SS}$. The resistors $R_1$ and $R_2$ have the same resistances from each other so that a connecting point $N_2$ between them provides the potential $V_{CC}/2$, where $V_{CC}$ is the voltage between the power supply line $V_{CC}$ and the ground line $V_{SS}$. The other electrode (opposite electrode) of the capacitor $C_1$ and the opposite electrodes of the other capacitors (not shown) in other memory cells are commonly connected to an opposite electrode line $OP_1$ which is connected to the connecting point $N_2$ between the resistors $R_1$ and $R_2$. Since the opposite electrode line $OP_1$ is common to a number of capacitors in the memory cells, it has a considerably large area. Therefore, there are considerably large parasitic capacitances between the opposite electrode line $OP_1$ and the bit line $BL_1$, bit line $\overline{BL}_1$, or the other nodes (not shown). In the figure, only the parasitic capacitances $CP_1$ and $CP_2$ are shown for the sake of simplicity, but in practice, there are more parasitic capacitances between the opposite electrode line $OP_1$ and the other nodes. In order to keep the potential at the opposite electrode line $OP_1$ to $V_{CC}/2$, the time constant derived from the resistances (also referred to as $R_1$ and $R_2$) in the voltage dividing circuit 1 and the parasitic capacitors, for example, $CP_1$ and $CP_2$, is preferably as small as possible. However, even when the memory device is unselected, that is, even during a reset interval, a current flows through the resistors $R_1$ and $R_2$. Therefore, if the resistances $R_1$ and $R_2$ are made small for obtaining a small time constant, a considerably large power is consumed in the resistors $R_1$ and $R_2$. To prevent the large power consumption, the resistors $R_1$ and $R_2$ are usually made to have high resistances. Because of the high resistances, the time constant is inevitably large.

When the time constant is considerably large, the potential at the opposite electrode line $OP_1$ is not kept at the constant potential $V_{CC}/2$, as shown in Figs. 2A, 2B, 3A, and 3B.

Figure 2A shows waveforms at some points in the dynamic RAM in Fig. 1. In Fig. 2A, a row address strobe ($\overline{RAS}$) causes the dynamic RAM to become active when it is at a low (L) level. When the $\overline{RAS}$ is turned to the L level, the dynamic RAM is enabled to effect a read or write operation. More particularly, the dynamic RAM fetches address signals so that the potential of the selected word line $WL_1$ is raised, in response to the transition from H to L level of the $\overline{RAS}$. When the potential of the word line $WL_1$ is raised to a high level, the transistor $Q_1$ is turned on. Before the word line potential is raised, that is, during a reset interval when the $\overline{RAS}$ is at a high (H) level, both of the bit lines $BL_1$ and $\overline{BL}_1$ are precharged to have the potential $V_{CC}$. When the capacitor $C_1$ has been charged up, that is, when the capacitor $C_1$ is storing a data "1", the charges on the bit line $BL_1$ dot not flow through the transistor $Q_1$ into the capacitor $C_1$ even after the transistor $Q_1$ is turned on, so that the potential of the bit line $BL_1$ is not changed by the rise of the potential of the word line $WL_1$, and the charges on the bit line $\overline{BL}_1$ flow into the dummy memory cell (not shown) so that the potential of the bit line $\overline{BL}_1$ is lowered. The sense amplifier SA detects and amplifies the potential difference between the bit lines $BL_1$ and $\overline{BL}_1$, so that the potential of the bit line $BL_1$ remains at the $V_{CC}$ and the potential of the bit line $\overline{BL}_1$ is lowered to a ground potential $V_{SS}$. In contrast to this, when the capacitor $C_1$ is storing a data "0", a converse result is obtained. In the following, the capacitor $C_1$ is assumed to be storing the data "1".

Due to the lowered potential of the bit line $\overline{BL}_1$, charges on the opposite electrode $OP_1$ flow into the parasitic capacitor $CP_2$ between the opposite electrode line $OP_1$ and the bit line $\overline{BL}_1$, causing the potential of the opposite electrode line $OP_1$ to be made lower than $V_{CC}/2$ by a voltage $\Delta V_{OPL}$. That is, the parasitic capacitor $CP_2$ is charged up in such a manner that the electrode of the capacitor $CP_1$ at the side of the opposite electrode line $OP_1$ is positive. Then, when the $\overline{RAS}$ is turned to the H level, the status of the dynamic RAM is turned to the subsequent reset interval so that the potentials of the bit lines $BL_1$ and $\overline{BL}_1$ are precharged to $V_{CC}$. Since the floating capacitor $CP_1$ has been charged up, the potential of the opposite elec-

trode line $OP_1$ is boosted to be higher than $V_{CC}/2$ by a voltage $\Delta V_{OPH}$. Thus, as previously mentioned, the potential of the opposite electrode line varies in response to the $\overline{RAS}$.

Since the opposite electrode line $OP_1$ is connected to the node $N_2$ which provides the constant potential $V_{CC}/2$, the potential of the opposite electrode line $OP_1$ will become $V_{CC}/2$ after a sufficiently long time in the reset interval or in the active interval. This causes a problem, as later described in detail.

If, however, the reset interval and the active interval are both relatively short, so that the potential

$$V_{CC}/2-\Delta V_{OPL}$$

or

$$V_{CC}/2+\Delta V_{OPH}$$

is not substantially changed during each interval, and if the duty ratio between the reset interval and the active interval is constant during read operation, no problem is caused. Fig. 2B shows the waveforms of the $\overline{RAS}$ and the potential of the opposite electrode line $OP_1$ when the dynamic RAM in Fig. 1 normally operates as mentioned above. In Fig. 2B, a relatively long term of operation is illustrated. Each reset interval is short and is the same as each active interval. In this case,

$$\Delta V_{OPH}=\Delta V_{OPL}.$$

The average potential of the opposite electrode line $OP_1$ is $V_{CC}/2$.

Now, a problem or disadvantage of the conventional dynamic RAM is explained with reference to Figs. 3A and 3B.

Figure 3A shows the waveforms of the $\overline{RAS}$ and the potential of the opposite electrode line $OP_1$ when one of the reset intervals is considerably long. As mentioned before, the potential of the opposite electrode line $OP_1$ decreases from

$$V_{CC}/2+\Delta V_{OPH}$$

to $V_{CC}/2$ during such a long reset interval, as illustrated. Therefore, at the beginning of the active interval followed by the long reset interval, the potential at the opposite electrode line $OP_1$ is $V_{CC}/2$ instead of

$$V_{CC}/2+\Delta V_{OPH}.$$

Figure 3B shows waveforms similar to those in Fig. 2A. The difference between Fig. 2A and Fig. 3B is that, in Fig. 3B, the potential of the opposite electrode line $OP_1$ at the beginning of an active interval is $V_{CC}/2$ instead of

$$V_{CC}/2+\Delta V_{OPH}.$$

Referring to Figs. 1 and 3B, if the potential of the opposite electrode line $OP_1$ at the beginning of the active interval is

$$V_{CC}/2+\Delta V_{OPH},$$

as is the case of Fig. 2A, the potential at the node $N_1$ is $V_{CC}$. However, if the potential of the opposite electrode line $OP_1$ at the beginning of the active interval is lowered to $V_{CC}/2$, as shown in Fig. 3A, it causes the potential at the node $N_1$ to be lowered from $V_{CC}$. As a result, a considerable amount of charges on the bit line $BL_1$, which has been precharged to $V_{CC}$, flow through the transistor $Q_1$ into the capacitor $C_1$, so that the potential of the bit line $BL_1$ may be lowered from $V_{CC}$ to a potential $V_{CC}-\Delta V$ which is lower than the lowered potential of the bit line $\overline{BL}_1$ at the beginning of the sensing operation. Thus, during an interval T, the sense amplifier SA erroneously detects that the potential of the bit line $BL_1$ is lower than the potential of the bit line $\overline{BL}_1$ although the capacitor $C_1$ is storing a data "1". The sense amplifier SA amplifies the potential difference between the bit lines $BL_1$ and $\overline{BL}_1$ so that the potential of the bit line $BL_1$ becomes the ground potential $V_{SS}$ and the potential of the bit line $\overline{BL}_1$ becomes the power supply potential $V_{CC}$. This results in a read error.

Even when the potential of the bit line $BL_1$ is not lowered much below the potential of the bit line $\overline{BL}_1$ during the interval T, the potential difference between the bit lines $BL_1$ and $\overline{BL}_1$ becomes very small, smaller than, for example, 50 millivolts, so that the sense amplifier, which can detect the potential difference greater than, for example, 50 millivolts may also give a read error operation.

In Fig. 3B, to enable easy understanding, the waveforms of the bit line $BL_1'$ and the opposite electrode line $OP_1'$ represent the normal operation shown in Fig. 2A.

According to the present invention, the above described read error in the conventional dynamic RAM is prevented by providing an improved voltage dividing circuit, which outputs $V_{CC}/2+\Delta_{OPH}$ during a reset interval and outputs $V_{CC}/2-\Delta_{OPL}$ during an active interval.

Embodiments of the present invention will be now described with reference to Figs. 4, 5A, 5B, and 6.

Figure 4 is a circuit diagram of a part of a dynamic RAM, according to an embodiment of the present invention. The difference between the conventional circuit in Fig. 1 and the circuit in Fig. 4 resides in the voltage dividing circuit. That is, in Fig. 4, a voltage dividing circuit 10 consists of resistors $R_{10}$ and $R_{20}$ connected in series between the power supply line $V_{CC}$ and the ground line $V_{SS}$, a resistor $R_{30}$, and a MOS transistor $Q_2$. The resistor $R_{30}$ and the MOS transistor $Q_2$ constitute a potential switching circuit. One end of the resistor $R_{30}$ is connected to a connecting point $N_{20}$ between the resistors $R_{10}$ and $R_{20}$. The connecting point $N_{20}$ is a potential providing terminal of the voltage dividing circuit 10. The other end of the resistor $R_{30}$ is connected to the drain of the MOS transistor $Q_2$. The source of the MOS transistor $Q_2$ is connected to the ground line $V_{SS}$. The gate of the MOS transistor $Q_2$ operatively receives a clock signal $\phi_A$ synchronous with the $\overline{RAS}$, so that the

MOS transistor $Q_2$ is operatively in an on state during an active interval and is operatively off during a reset interval. That is, the clock signal $\phi_A$ is a signal in which it is at the H level during an active interval and at the L level during a reset interval.

This clock signal $\phi_A$ may be delayed with respect to the $\overline{RAS}$ by a relatively short period of time if it is negligible as compared to the time constant of the voltage dividing circuit 10. Such a delay is even preferable if it makes the clock signal $\phi_A$ completely synchronous with the change of the potential at the opposite electrode line $OP_{10}$.

When the transistor $Q_2$ is in an off state, that is, during a reset interval, the potential $V_{N20}$ of the potential providing terminal $N_{20}$ is determined only by the resistors $R_{10}$ and $R_{20}$, i.e.,

$$V_{N20}=\frac{R_{20}}{R_{10}+R_{20}}V_{CC}.$$

The resistances of the resistors $R_{10}$ and $R_{20}$ are so determined as to satisfy the following expression (1):

$$\frac{R_{20}}{R_{10}+R_{20}}V_{CC}=\tfrac{1}{2}V_{CC}+\Delta V_{OPH} \qquad (1)$$

where $R_{10}$ and $R_{20}$ represent the resistances of the resistors $R_{10}$ and $R_{20}$, respectively. At the beginning of the reset interval, the potential of the opposite electrode line $OP_{10}$ is $V_{CC}+\Delta V_{OPH}$, as described before in the explanation of the conventional dynamic RAM. Therefore, the potential of the opposite electrode line $OP_{10}$ is fixed to

$$V_{CC}/2+\Delta V_{OPH}$$

during the reset interval.

When the transistor $Q_2$ is in an on state, that is, during an active interval, the potential $V_{N20}$ of the potential providing terminal $N_{20}$ is determined by the resistors $R_{10}$, $R_{20}$, and $R_{30}$, i.e., when the resistance of the resistor $R_{30}$ is also expressed by $R_{30}$, then,

$$V_{N20}=\frac{R_4}{R_{10}+R_4}V_{CC},$$

where

$$R_4=\frac{R_{20}\,R_{30}}{R_{20}+R_{30}}.$$

The resistance of the resistor $R_{30}$ is so determined as to satisfy the following expression (2):

$$\frac{R_4}{R_{10}+R_4}V_{CC}=\tfrac{1}{2}V_{CC}-\Delta V_{OPL} \qquad (2)$$

At the beginning of the active interval, the potential of the opposite electrode line $OP_{10}$ is

$$V_{CC}/2-\Delta V_{OPL},$$

as described before. Therefore, the potential of the opposite electrode line $OP_{10}$ is fixed to

$$V_{CC}/2-\Delta V_{OPL}$$

during the active interval.

The voltages $\Delta V_{OPH}$ and $\Delta V_{OPL}$ are experimentally determined.

From the above expression (1), it is apparent that the resistance $R_{10}$ is smaller than the resistance $R_{20}$. From the above expression (2), it is apparent that the resistance $R_4$ is smaller than the resistance $R_{10}$.

Figure 5A shows the waveforms of the $\overline{RAS}$, the clock signal $\phi_A$ and the potential of the opposite electrode line $OP_{10}$ when a reset interval is longer than an active interval. As can be seen, the potential of the opposite electrode line $OP_{10}$ is not decreased from $V_{CC}/2+\Delta V_{OPH}$ to $V_{CC}/2$ but is fixed to $V_{CC}/2+\Delta V_{OPH}$ during the reset interval. In Fig. 5A, $OP_1$ represents the potential of the opposite electrode line $OP_1$ in the conventional dynamic RAM shown in Fig. 1, for easy understanding.

Figure 5B shows the waveforms of the $\overline{RAS}$ and the opposite electrode line $OP_{10}$ when an active interval is longer than a reset interval. As can be seen, the potential of the opposite electrode line $OP_{10}$ is not increased from

$$V_{CC}/2-\Delta V_{OPL}$$

to $V_{CC}/2$ but is fixed to

$$V_{CC}/2-\Delta V_{OPL}$$

during the reset interval.

Even when the duty ratio between the active interval and the reset interval is not constant, the potential of the opposite electrode line $OP_{10}$ is always constant in each interval.

As a result, according to the embodiment shown in Fig. 4, the potential at the node $N_1$, and therefore, at the bit line $BL_{10}$ does not change during a sense operation so that a read error is prevented.

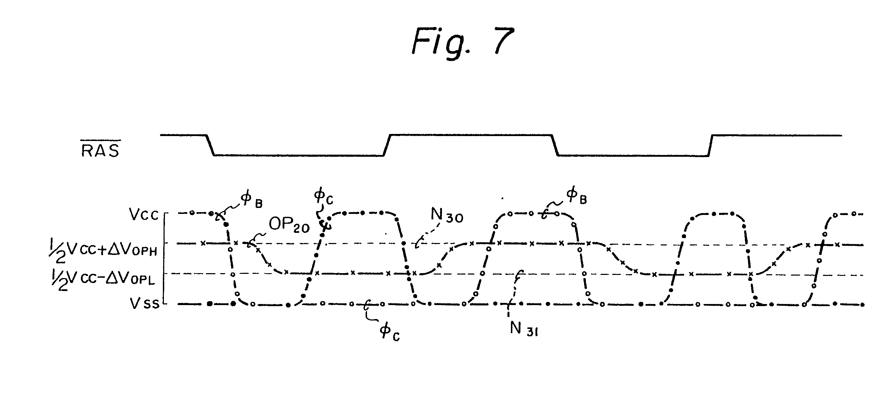

Figure 6 is a circuit diagram of a part of a dynamic RAM, according to another embodiment of the present invention. The difference between Fig. 4 and Fig. 6 resides in a voltage dividing circuit 11. That is, in Fig. 6, the voltage dividing circuit 11 comprises resistors $R_{10}$ and $R_{20}$ connected in series between the power supply line $V_{CC}$ and the ground line $V_{SS}$, resistors $R_{31}$ and $R_{41}$ connected in series between the power supply line $V_{CC}$ and the ground line $V_{SS}$, and two MOS transistors $Q_3$ and $Q_4$. The drain of the MOS

transistor $Q_3$ is connected to a connecting point $N_{30}$ between the resistors $R_{10}$ and $R_{20}$, and the drain of the MOS transistor $Q_4$ is connected to a connecting point $N_{31}$ between the resistors $R_{31}$ and $R_{41}$. The sources of the transistors $Q_3$ and $Q_4$ are commonly connected to a potential providing terminal $N_{32}$ which is connected to the opposite electrode line $OP_{20}$. The gate of the transistor $Q_3$ operatively receives a clock signal $\phi_B$ synchronous with the $\overline{RAS}$ so that the MOS transistor $Q_3$ is operatively in an on state during a reset interval and is operatively off during an active interval. That is, the clock signal $\phi_B$ is a signal in which it is at the H level during a reset interval and at the L level during an active interval. The gate of the transistor $Q_4$ operatively receives a clock signal $\phi_C$ which has a phase different by 180° with respect to the phase of the clock signal $\phi_B$. Therefore, the MOS transistor $Q_4$ is operatively in an on state during an active interval and is operatively in an off state during a reset interval. The resistances of the resistors $R_{10}$ and $R_{20}$ are determined to satisfy the expression (1) described before. The resistances of the resistors $R_{31}$ and $R_{41}$ are determined to satisfy the following expression:

$$\frac{R_{41}}{R_{31}+R_{41}}=\tfrac{1}{2}V_{CC}-\Delta V_{OPL} \quad (3)$$

By this constitution, as shown in Fig. 6, the potential change at the potential providing terminal $N_{32}$ in response to the clock signals $\phi_B$ and $\phi_C$ is effected rapidly in comparison with the voltage dividing circuit 10 in Fig. 4. This is because, in Fig. 4, the potential providing terminal $N_{20}$ is connected through the resistor $R_{30}$ to the drain of the transistor $Q_2$, and there exists a time constant derived from the resistance $R_{30}$ and parasitic capacitances of the MOS transistor $Q_2$. Due to the time constant, the rise or fall of the potential of the opposite electrode line $OP_{10}$ is slightly delayed, although this delay is negligible. In contrast, in Fig. 6 since, the drain of the transistor $Q_3$ is directly connected to the connecting point between resistors $R_{10}$ and $R_{20}$, and since the drain of the transistor $Q_4$ is directly connected to the connecting point $N_{31}$ between the resistors $R_{31}$ and $R_{41}$, the time constant is small in comparison with that in Fig. 4.

Fig. 7 illustrates a detailed timing diagram for the clock signals $\phi_B$ and $\phi_C$ used in the circuit shown in Fig. 6. In Fig. 7, the potential of the opposite electrode line $OP_{20}$ changes between

$$V_{CC}/2+\Delta V_{OPM}$$

and

$$V_{CC}/2-\Delta V_{OPL}$$

in the accordance with the operation of the memory device. The nodes $N_{30}$ and $N_{31}$ in the voltage dividing circuit 11 respectively generate the potential

$$V_{CC}/2+\Delta V_{OPH}$$

and

$$V_{CC}/2-\Delta V_{OPL},$$

by means of the resistors $R_{10}$ and $R_{20}$ and, $R_{31}$ and $R_{41}$. In such a situation as above, the potential of the clock signal $\phi_C$ is raised to turn on the transistor $Q_4$ after the potential of the opposite electrode line $OP_{20}$ is sufficiently lowered to

$$V_{CC}/2-\Delta V_{OPL}.$$

Then the potential of the clock signal $\phi_C$ is lowered to turn off the transistor $Q_4$ before the potential of the opposite electrode line $OP_{20}$ changes from

$$V_{CC}/2-\Delta V_{OPL}.$$

Similarly, the potential of the clock signal $\phi_3$ is raised to turn on the transistor $Q_3$ after the potential of the opposite electrode line $OP_{20}$ sufficiently reach

$$V_{CC}/2+\Delta V_{OPH}.$$

Then the potential of the clock signal $\phi_B$ is lowered to turn off the transistor $Q_3$ before the potential of the opposite electrode line $OP_{20}$ changes. As a result, the transistors $Q_3$ and $Q_4$ are turned on only during intervals in which the potentials of the opposite electrode line $OP_{20}$ are

$$V_{CC}/2+\Delta V_{OPH}$$

and

$$V_{CC}/2-\Delta V_{OPL},$$

respectively.

According to the embodiment in Fig. 4, it is difficult to establish the timing for turning on or off of the transistor $Q_2$ because the potential change of the opposite electrode line $OP_{10}$ between

$$V_{CC}/2+\Delta V_{OPH}$$

and

$$V_{CC}/2-\Delta V_{OPL}$$

is slow.

To the contrary, according to the embodiment in Fig. 6, such a difficulty is not present.

The clock signals $\phi_A$ in Fig. 4, and $\phi_B$ and $\phi_C$ in Fig. 6 can be obtained by utilizing internal clock signals in the dynamic RAM which are synchronous with the $\overline{RAS}$.

The resistors $R_{10}$, $R_{20}$, $R_{30}$, $R_{31}$ and $R_{41}$ themselves in Figs. 4 and 6 are obtained by conventional techniques, that is, by polycrystalline silicon film, by depletion MOS transistors, or by diffusion layers. The resistance of each resistor is in an order of, for example, 50 kΩ.

According to both embodiments, the potential of the opposite electrode line $OP_{10}$ or $OP_{20}$ is substantially kept to

$$V_{CC}/2+\Delta V_{OPH}$$

or

$$V_{CC}/2-\Delta V_{OPL}$$

during each reset interval or each active interval, respectively. The average potential of the opposite electrode line $OP_{10}$ or $OP_{20}$ for a long period is equal to $V_{CC}/2$, which is sufficiently low with respect to the tolerance voltage of the capacitor in each memory cell.

In the foregoing embodiments, the potential of the opposite electrode line is raised to be higher than $V_{CC}/2$ at the beginning of each reset interval, and is lowered to be lower than $V_{CC}/2$ at the beginning of each active interval. The present invention, however, is not restricted to the above mentioned case. That is, the opposite electrode line forms parasitic capacitance with various nodes, for example bit lines. Therefore, in response to changes in the potential at those nodes, the potential of the opposite electrode line also fluctuates. The present invention is applicable to eliminate malfunctions caused by such fluctuations. Accordingly, the essence of the present invention lies in the design of the voltage dividing circuit shown in Fig. 4 or Fig. 6, in which its output potential is changed in conformity with changes of the potential at the opposite electrode line which is caused by and synchronous with the read or write operation of the device.

From the foregoing description, it will be apparent that, according to the present invention, by providing an improved voltage dividing circuit for providing intermediate potentials between $V_{CC}$ and $V_{SS}$ in a dynamic semiconductor memory device, and since the voltage dividing circuit can switch its output potential in accordance with the change of the potential of the opposite electrode in the capacitor in each memory cell, a read error operation in a dynamic semiconductor memory device can be prevented even when the cycle time is changed, or when the reset interval or the active interval is very long, or when the duty ratio between the reset interval and the active interval is changed.

**Claims**

1. A dynamic semiconductor memory device comprising a one-transistor one-capacitor dynamic memory cell, a word line ($WL_{10}$), a bit line ($BL_{10}$), and a voltage dividing circuit ($R_{10}$, $R_{20}$) having a potential-providing terminal for providing an intermediate potential between a power supply potential and a ground potential; the single transistor ($Q_1$) of the cell having a gate electrode connected to the word line and having two other electrodes; the single capacitor ($C_1$) of the cell having a first electrode, which is connected to one of the said other electrodes of the transistor, and an opposite electrode which is operatively connected to the potential-providing terminal ($N_{20}$) of the voltage dividing circuits; characterised in that the voltage-dividing circuit comprises a potential switching circuit ($R_{30}$, $Q_2$) for changing the intermediate potential in the voltage dividing circuit synchronously with the operation of the memory device to provide a potential at which the intermediate potential is shifted towards the direction of the potential change of the opposite electrode of the capacitor due to capacitive coupling accompanied by the memory operation.

2. A dynamic semiconductor memory device as set forth in claim 1, wherein the potential-switching circuit s driven by an internal clock signal ($\phi_A$) obtained from a row address strobe signal ($\overline{RAS}$) for providing alternate sequences of an active interval and a reset interval of the memory device.

3. A dynamic semiconductor memory device as set forth in claim 1 or 2, wherein the potential-switching circuit in the voltage-dividing circuit operatively provides a first potential higher than the half of the power supply potential by a first predetermined value during at least a part of each of the reset intervals, and operatively provides a second potential lower than the half of the power supply potential by a second predetermined value during at least a part of each of the active intervals.

4. A dynamic semiconductor memory device as set forth in claim 1, 2 or 3, wherein the voltage-dividing circuit comprises a first resistor ($R_{10}$) and a second resistor ($R_{20}$) connected in series between a power supply line ($V_{CC}$) and a ground line ($V_{SS}$), the potential-switching circuit in the voltage-dividing circuit comprises a third resistor ($R_{30}$) and a switching transistor ($Q_2$) having a control electrode for turning on or off the switching transistor, to switch the intermediate potential at the potential-providing terminal from the first potential to the second potential and having two other electrodes, one end of the third resistor being connected to a connecting point between the first resistor and the second resistor, the other end of the third resistor being connected to one of the two other electrodes of the switching transistor, the other of the two other electrodes of the switching transistor being connected to the ground line, the connecting point being connected to the potential-providing terminal.

5. A dynamic semiconductor memory device as set forth in claim 4, wherein the resistance values of the first resistor, the second resistor, and the third resistor are so determined that the change of the potential at the potential-providing terminal is equal to the change of the potential at the second electrode of the capacitor which is generated by the operation of the memory device.

6. A dynamic semiconductor memory device as set forth in claim 4 or 5, wherein the resistance value of the first resistance ($R_{10}$) is smaller than the resistance value of the second resistor ($R_{20}$), and the resistance value of the second resistor ($R_{20}$) and the third resistor ($R_{30}$) when connected in parallel is smaller than the resistance value of the first resistor.

7. A dynamic semiconductor memory device as set forth in any one of claims 1 to 3, wherein the voltage-dividing circuit comprises a first resistor

($R_{10}$) and a second resistor ($R_{20}$) connected in series between a power supply line and a ground line, a third resistor ($R_{31}$) and a fourth resistor ($R_{41}$) connected in series between the power supply line and the ground line, a first switching transistor ($Q_3$) having a first control electrode for turning on or off the first switching transistor and having two other electrodes, and a second switching transistor ($Q_4$) having a second control electrode for turning on or off the second switching transistor and having two other electrodes, one of the two other electrodes of the first switching transistor being connected to a first connecting point ($N_{30}$) between the first resistor and the second resistor, one of the two other electrodes of the second switching transistor being connected to a second connecting point ($N_{31}$) between the third resistor and the fourth resistor, the other of the two other electrodes of the first switching transistor and the other of the two other electrodes of the second switching transistor being commonly connected to the potential-providing terminal ($N_{32}$), the first control electrode operatively receiving a first internal clock signal ($\phi_B$) and the second control electrode operatively receiving a second internal clock signal ($\phi_C$) having a phase different by 180° with respect to the phase of the first internal clock signal, the first and second internal clock signals being synchronous with the operation of the memory device.

8. A dynamic semiconductor memory device as set forth in claim 7, wherein the first and second switching transistors are operatively in on and off states respectively during a reset interval of the operation of the memory device, and operatively in off and on states respectively during an active interval of the operation of the memory device.

9. A dynamic semiconductor memory device as set forth in claim 8, wherein the resistance value of the first resistor is smaller than the resistance value of the second resistor, and the resistance value of the third resistor is greater than the resistance value of the fourth resistor.

**Patentansprüche**

1. Dynamische Halbleiterspeichervorrichtung mit einer dynamischen ein-Transistor-ein-Kondensator-Speicherzelle, einer Wortleitung ($WL_{10}$), einer Bitleitung ($BL_{10}$) und einer Spannungsteilerschaltung ($R_{10}$, $R_{20}$), die einen ein Potential liefernden Anschluß hat, um ein Zwischenpotential zwischen einem Energieversorgungspotential und einem Erdpotential zu liefern; wobei der einzige Transistor ($Q_1$) der Zelle eine Gateelektrode, die mit der Wortleitung verbunden ist, und zwei andere Elektroden hat; der einzige Kondensator ($C_1$) der Zelle eine erste Elektrode, die mit der einen der genannten anderen Elektrode des Transistors verbunden ist und eine gegenüberliegende Elektrode hat, die wirkungsmäßig mit dem das Potential liefernden Anschluß ($N_{20}$) der Spannungsteilerschaltung verbunden ist; dadurch gekennzeichnet, daß die Spannungsteilerschaltung einen Potentialschaltkreis ($R_{30}$, $Q_2$) umfaßt, zur Änderung des Zwischenpotentials in der Spannungsteilersschaltung synchron mit dem Betrieb der Speichereinrichtung, um ein Potential vorzusehen, bei welchem das Zwischenpotential auf Grund der kapazitiven Kopplung, die von dem Speicherbetrieb begleitet wird, in Richtung auf die Potentialänderung der gegenüberliegenden Elektrode des Kondensators verschoben wird.

2. Dynamische Halbleiterspeichervorrichtung nach Anspruch 1, bei der der Potentialschaltkreis s durch ein internes Taktsignal ($\phi_A$) getrieben wird, das von einem Reihenadreß-Strobesignal ($\overline{RAS}$) erhalten wird, um alternierende Sequenzen von einem aktiven Intervall und einem Rücksetzintervall der Speichervorrichtung zu liefern.

3. Dynamische Halbletierspeichervorrichtung nach Anspruch 1 oder 2, bei der der Potentialschaltkreis in dem Spannungsteilerkreis wirkungsmäßig ein erstes Potential liefert, das um einen ersten vorbestimmten Wert höher als die Hälfte des Energieversorgungspotentials ist, während wenigstens eines Teils von jedem der Rücksetzintervalle, und wirkungsmäßig ein zweites Potential liefert, daß um einen zweiten vorbestimmten Wert niedriger als die Hälfte des Energieversorgungspotentials ist, während wenigstens einem Teil von jedem der aktiven Intervalle.

4. Dynamische Halbleiterspeichervorrichtung nach einem der Ansprüche 1, 2 oder 3, bei der die Spannungsteilerschaltung einen ersten Widerstand ($R_{10}$) und einen zweiten Widerstand ($R_{20}$) umfaßt, die in Reihe zwischen einer Energieversorgungsleitung ($V_{CC}$) und einer Erdleitung ($V_{SS}$) verbunden sind, wobei der Potentialschaltkreis in der Spannungsteilerschaltung einen dritten Widerstand ($R_{30}$) und einen Schalttransistor ($Q_2$) umfaßt, der eine Steuerelektrode zum Ein- oder Ausschalten des Schalttransistors hat, um das Zwischenpotential bei dem ein Potential liefernden Anschluß von dem ersten Potential zu dem zweiten Potential zu liefern, und zwei weitere Elektroden hat, wobei ein Ende des dritten Widerstandes mit einem Verbindungspunkt zwischen dem ersten Widerstand und dem zweiten Widerstand verbunden ist, und das andere Ende des dritten Widerstands mit einer von den beiden anderen Elektroden des Schalttransistors verbunden ist, wobei die andere der beiden anderen Elektroden des Schalttransistors mit der Erdleitung verbunden ist und der Verbindungspunkt mit dem ein Potential liefernden Anschluß verbunden ist.

5. Dynamische Halbleiterspeichervorrichtung nach Anspruch 4, bei der die Widerstandswerte des ersten Widerstands, des zweiten Widerstands und des dritten Widerstands so bestimmt sind, daß die Änderung des Potentials bei dem ein Potential liefernden Anschluß gleich der Änderung des Potentials bei der zweiten Elektrode des Kondensators ist, welches durch den Betrieb der Speichervorrichtung erzeugt wird.

6. Dynamische Halbleiterspeichervorrichtung nach Anspruch 4 oder 5, bei der der Widerstandswert des ersten Widerstands ($R_{10}$) kleiner als der

Widerstandswert des zweiten Widerstands ($R_{20}$) ist, und der Widerstandswert des zweiten Widerstands ($R_{20}$) und des dritten Widerstands ($R_{30}$), wenn sie parallel verbunden sind, kleiner als der Widerstandswert des ersten Widerstands ist.

7. Dynamische Halbleiterspeichervorrichtung nach einem der Ansprüche 1 bis 3, bei der die Spannungsteilerschaltung einen ersten Widerstand ($R_{10}$) und einen zweiten Widerstand ($R_{20}$) umfaßt, die in Reihe zwischen einer Energieversorgungsleitung und einer Erdleitung verbunden sind, ein dritter Widerstand ($R_{31}$) und ein vierter Widerstand ($R_{41}$) in Reihe zwischen der Energieversorgungsleitung und der Erdleitung verbunden sind, ein erster Schalttransistor ($Q_3$) eine erste Steuerelektrode hat, um den ersten Schalttransistor ein- oder auszuschalten, und zwei weitere Elektroden hat, und ein zweiter Schalttransistor ($Q_4$) eine zweite Steuerelektrode hat, um den zweiten Schalttransistor ein- oder auszuschalten, und zwei weitere Elektroden hat, wobei eine der beiden weiteren Elektroden des ersten Schalttransistors mit einem ersten Verbindungspunkt ($N_{30}$) zwischen dem ersten Widerstand und dem zweiten Widerstand verbunden ist, eine der beiden anderen Elektroden des zweiten Schalttransistors mit einem zweiten Verbindungspunkt ($N_{31}$) zwischen dem dritten Widerstand und dem vierten Widerstand verbunden ist, die andere der beiden weiteren Elektroden des ersten Schalttransistors und die andere der beiden weiteren Transistoren des zweiten Schalttransistors gemeinsam mit dem ein Potential liefernden Anschluß ($N_{32}$) verbunden sind, die erste Steuerelektrode wirkungsmäßig ein erstes internes Taktsignal ($\phi_B$) empfängt und die zweite Steuerelektrode wirkungsmäßig ein zweites internes Taktsignal ($\phi_C$) empfängt, das eine Phasendifferenz von 180° in Bezug auf die Phase des ersten internen Taktsignals hat, wobei das erste und zweite interne Taktsignal synchron mit dem Betrieb der Speichervorrichtung sind.

8. Dynamische Halbletierspeichervorrichtung nach Anspruch 7, bei der die ersten und zweiten Schalttransistoren während eines Rücksetzintervalls des Betriebs der Speichervorrichtung in Ein- bzw. Aus-Zuständen sind, und wirkungsmäßig während eines aktiven Intervalls des Betriebs der Speichervorrichtung in Aus- bzw. Ein-Zuständen sind.

9. Dynamische Halbleiterspeichervorrichtung nach Anspruch 8, bei der der Widerstandswert des ersten Widerstands kleiner als der Widerstandswert des zweiten Widerstands ist, und der Widerstandswert des dritten Transistors größer als der Widerstandswert des vierten Transistors ist.

**Revendications**

1. Un dispositif de mémoire dynamique à semiconducteurs comprenant une cellule de mémoire dynamique à un transistor et un condensateur, une ligne de mot ($WL_{10}$), une ligne de bit ($BL_{10}$), et un circuit de division de tension ($R_{10}$, $R_{20}$) ayant une borne de sortie de potential destinée à fournir un potential intermédiaire entre un potentiel d'alimentation et un potential de masse; le transistor unique ($Q_1$) de la cellule ayant une électrode de grille connectée à la ligne de mot et ayant deux autres électrodes; le condensateur unique ($C_1$) de la cellule ayant une première électrode, qui est connectée à l'une des autres électrodes du transistor, et une électrode opposée qui est connectée fonctionnellement à la borne de sortie de potentiel ($N_{20}$) des circuits de division de tension; caractérisé en ce que le circuit de division de tension comprend un circuit de commutation de potential ($R_{30}$, $Q_2$) destiné à changer le potential intermédiaire dans le circuit de division de tension, en synchronisme avec le fonctionnement du dispositif de mémoire pour fournir un potentiel auquel le potentiel intermédiaire est décalé, en direction du changement de potentiel de l'électrode opposée du condensateur sous l'effet du couplage capacitif qui accompagne le fonctionnement de la mémoire.

2. Un dispositif de mémoire dynamique à semiconducteurs selon la revendication 1, dans lequel le circuit de commutation de potential est attaqué par un signal d'horloge interne ($\phi_A$) qui est obtenu à partir d'un signal de validation d'adresse de rangée ($\overline{RAS}$) destiné à établir des séquences alternées d'un intervalle actif et d'un intervalle de restauration du dispositif de mémoire.

3. Un dispositif de mémoire dynamique à semiconducteurs selon la revendication 1 ou 2, dans lequel le circuit de commutation de potentiel dans le circuit de division de tension fournit un premier potential supérieur d'une première valeur prédéterminée à la moitié du potential d'alimentation, pendant au moins une partie de chacun des intervalles de restauration, et il fournit un second potential, inférieur d'une seconde valeur prédéterminée à la moitié du potential d'alimentation, pendant au moins une partie de chacun des intervalles actifs.

4. Un dispositif de mémoire dynamique à semiconducteurs selon la revendication 1, 2 ou 3, dans lequel le circuit de division de tension comprend une première résistance ($R_{10}$) et une seconde résistance ($R_{20}$), connectées en série entre une ligne d'alimentation ($V_{CC}$) et une ligne de masse ($V_{SS}$), le circuit de commutation de potential dans le circuit de division de tension comprend une troisième résistance ($R_{30}$) et un transistor de commutation ($Q_2$) ayant une électrode de commande pour bloquer ou débloquer le transistor de commutation, dans le but de commuter du premier potentiel vers le second potential le potentiel intermédiaire sur la borne de sortie de potential, et ce transistor ayant deux autres électrodes, avec une extrémité de la troisième résistance connectée à un point de connexion entre la première résistance et la seconde résistance, et l'autre extrémité de la troisième résistance connectée entre l'une des deux autres électrodes du transistor de commutation, l'autre électrode parmi les deux autres électrodes du transistor de commmutation étant connectée à la ligne de masse, et le

point de connexion étant connecté à la borne de sortie de potentiel.

5. Un dispositif de mémoire vive dynamique à semiconducteurs selon la revendication 4, dans lequel les valeurs de la première résistance, de la seconde résistance et de la troisième résistance sont déterminées de façon que le changement du potentiel sur la borne de sortie de potentiel soit égal au changement du potential sur la seconde électrode du condensateur qui est produit par le fonctionnement du dispositif de mémoire.

6. Un dispositif de mémoire dynamique à semiconducteurs selon la revendication 4 ou 5, dans lequel la valeur de la première résistance ($R_{10}$) est inférieure à al valeur de la seconde résistance ($R_{20}$), et la valeur de la seconde résistance ($R_{20}$) et de la troisième résistance ($R_{30}$), lorsque'elles sont connectées en parallèle, est inférieure à la valeur de la première résistance.

7. Un dispositif de mémoire dynamique à semiconducteurs selon l'une quelconque des revendications 1 à 3, dans lequel le circuit de division de tension comprend une première résistance ($R_{10}$) et une seconde résistance ($R_{20}$) connectées en série entre une ligne d'alimentation et une ligne de masse, une troisième résistance ($R_{31}$) et une quatrième résistance ($R_{41}$) connectées en série entre la ligne d'alimentation et la ligne de masse, un premier transistor de commutation ($Q_3$) ayant une première électrode de commande pour bloquer ou débloquer le premier transistor de commutation et ayant deux autres électrodes, et un second transistor de commutation ($Q_4$) ayant une seconde électrode de commande pour bloquer ou débloquer le second transistor de commutation et ayant deux autres électrodes, l'une des deux autres électrodes du premier transistor de commutation étant connectée à un premier point de connexion ($N_{30}$) entre la première résistance et la seconde résistance, l'une des deux autres électrodes du second transistor de commutation étant connectée à un second point de connexion ($N_{31}$) entre la troisième résistance et la quatrième résistance, l'autre électrode parmi les deux autres électrodes du premier transistor de commutation et l'autre électrode parmi les deux autre électrodes du second transistor de commutation étant connectées en commun à la borne de sortie de potential ($N_{32}$), la première électrode de commande recevant un premier signal d'horloge interne ($\phi_B$) et la seconde électrode de commande recevant un second signal d'horloge interne ($\phi_C$) ayant une phase qui diffère de 180° par rapport à la phase du premier signal d'horloge interne, et les premier et second signaux d'horloge internes étant en synchronisme avec le fonctionnement du dispositif de mémoire.

8. Un dispositif de mémoire dynamique à semiconducteurs selon la revendication 7, dans lequel les premier et second transistors de commutation sont respectivement dans des états fonctionnels conducteur et bloqué pendant un intervalle de restauration du fonctionnement du dispositif de mémoire, et ils sont respectivement dans des états fonctionnels bloqué et conducteur pendant un intervalle actif du fonctionnement du dispositif de mémoire.

9. Un dispositif de mémoire dynamique à semiconducteurs selon la revendication 8, dans lequel la valeur de la première résistance est inférieure à la valeur de la seconde résistance, et la valeur de la troisième résistance est supérieure à la valeur de la quatrième résistance.

Fig. 1

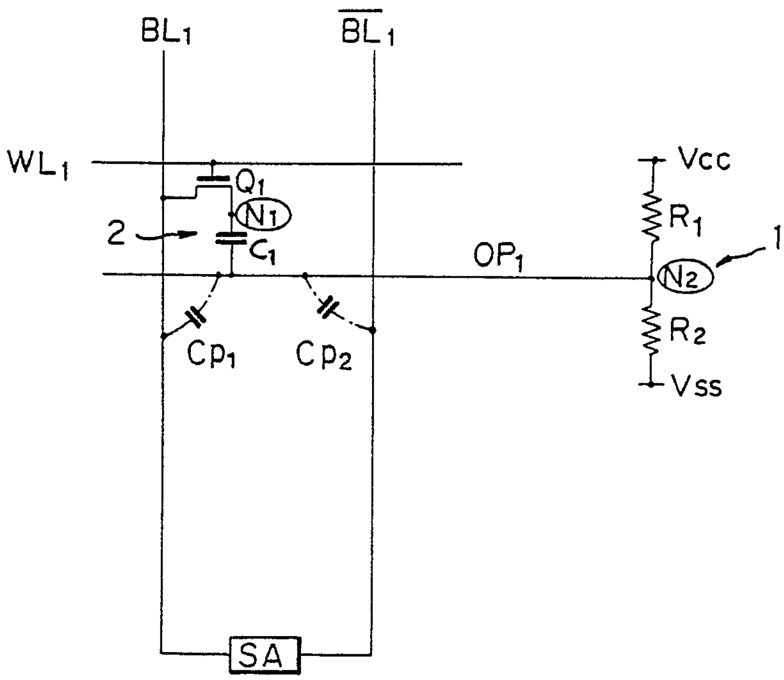

Fig. 2A

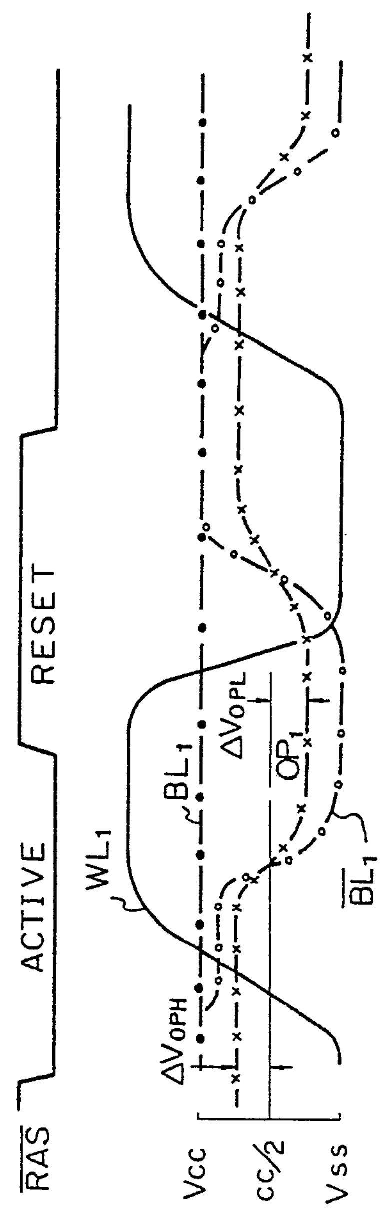
RAS
ACTIVE
RESET
WL1
BL1
ΔVOPH
ΔVOPL
OP1
BL1
Vcc
Vcc/2
Vss

Fig. 2B

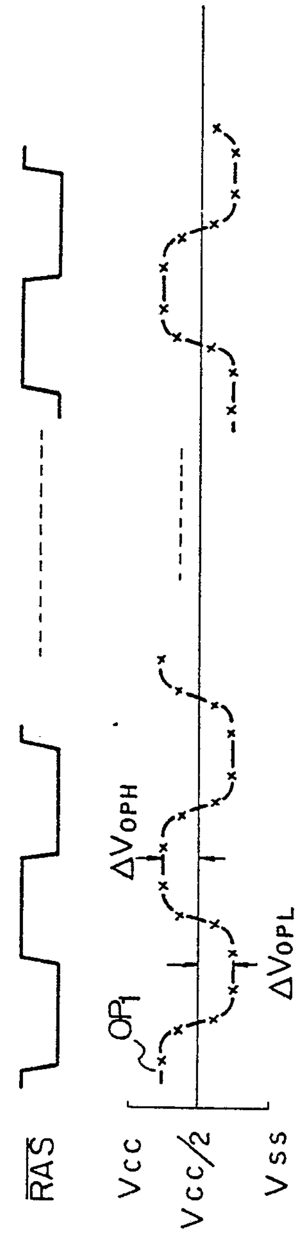
RAS
Vcc
Vcc/2
Vss
OP1
ΔVOPH
ΔVOPL

Fig. 3A

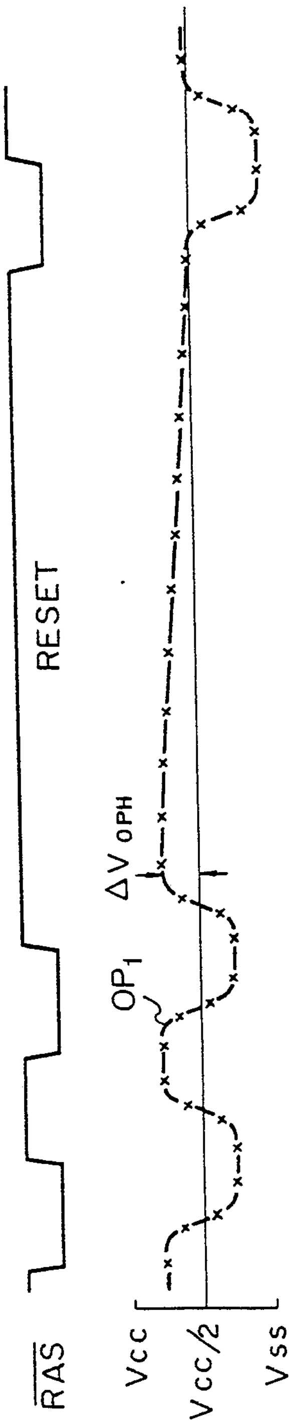
RESET
$\overline{RAS}$
Vcc
Vcc/2
Vss
$OP_1$
$\Delta V_{OPH}$

Fig. 3B

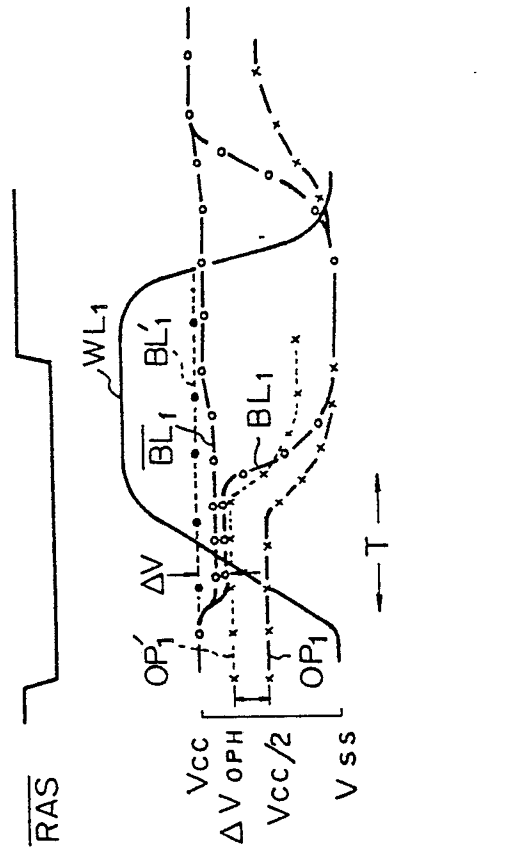
$\overline{RAS}$
Vcc
$\Delta V_{OPH}$
Vcc/2
Vss
$WL_1$
$BL_1'$
$\overline{BL_1}$
$BL_1$
$\Delta V$
$OP_1'$
$OP_1$
T

Fig. 4

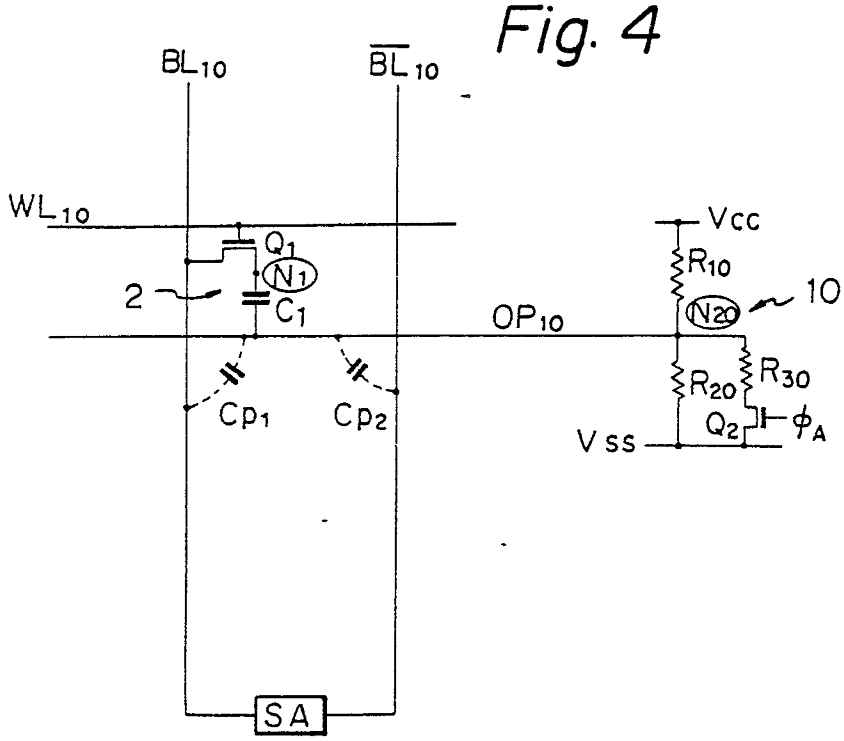
BL10
BL10
WL10
Q1
N1
2
C1
OP10
Cp1
Cp2
SA
Vcc
R10
N20
10
R20
R30
Q2
φA
Vss

Fig. 6

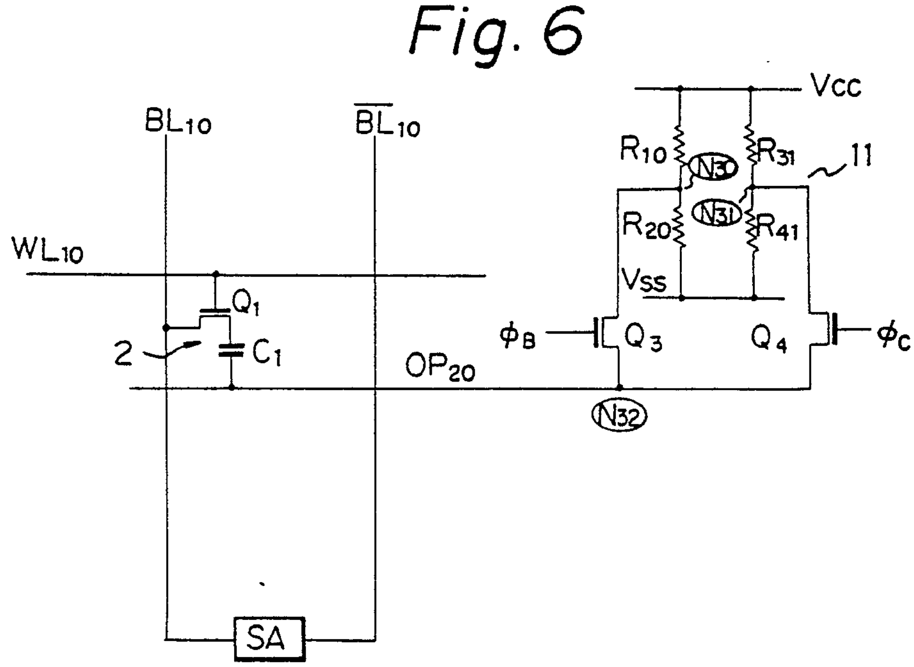
BL10
BL10
WL10
Q1
2
C1
OP20
SA
Vcc
R10
N30
R31
11
N31
R20
R41
Vss
φB
Q3
Q4
φC
N32

Fig. 5A

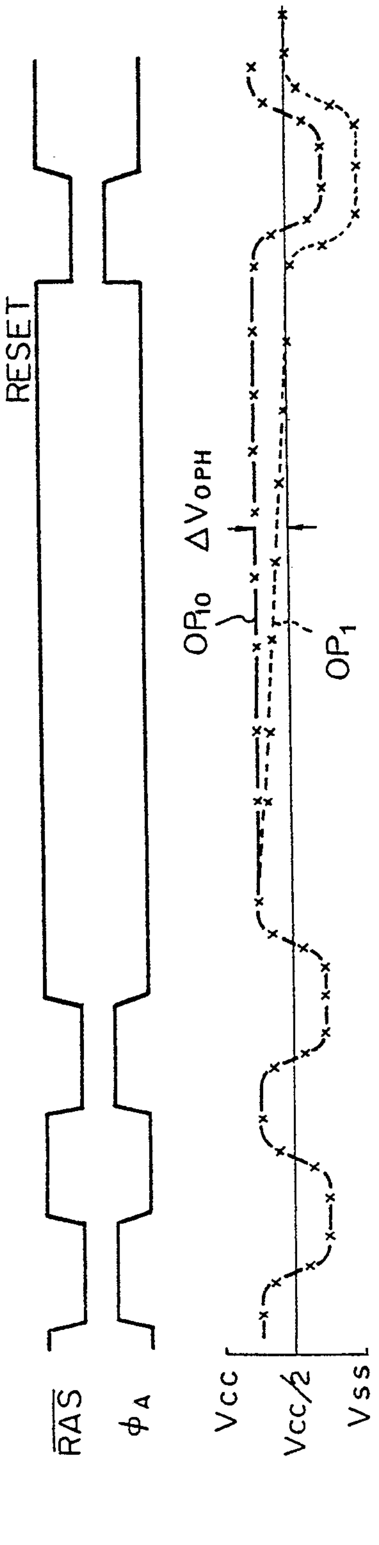
RESET
$\overline{RAS}$
$\phi_A$
Vcc
Vcc/2
Vss
$OP_{10}$
$OP_1$
$\Delta V_{OPH}$

Fig. 5B

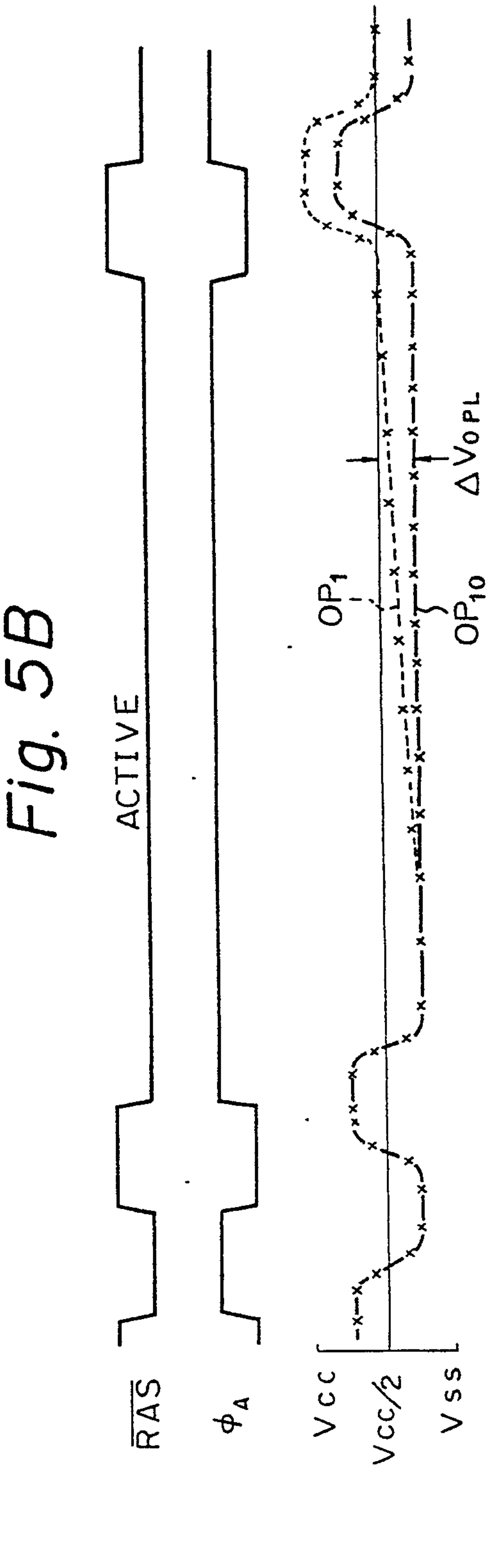
ACTIVE
$\overline{RAS}$
$\phi_A$
Vcc
Vcc/2
Vss
$OP_1$
$OP_{10}$
$\Delta V_{OPL}$

Fig. 7